(19)

Europäisches Patentamt

European Patent Office

Office européen des brevets

(11) **EP 2 488 005 A2**

(12) **EUROPÄISCHE PATENTANMELDUNG**

(43) Veröffentlichungstag:
**15.08.2012  Patentblatt 2012/33**

(51) Int Cl.:
**H05K 7/20** *(2006.01)*

(21) Anmeldenummer: **12000438.7**

(22) Anmeldetag: **24.01.2012**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **10.02.2011  DE 102011000638**

(71) Anmelder: **RITTAL GmbH**
**35745 Herborn (DE)**

(72) Erfinder:
• **Nicolai, Michael**
  **35466 Rabenaul (DE)**
• **Dörrich,  Martin**
  **35756 Mittenaar (DE)**

(74) Vertreter: **Tönhardt, Marion**
**Boehmert & Boehmert**
**Pettenkoferstrasse 20-22**
**80336 München (DE)**

(54) **Verfahren und Vorrichtung zur Regelung und Überwachung eines Klimasystems für Datenverarbeitungsanlagen**

(57)    Die Erfindung betrifft ein Verfahren zur Regelung und Überwachung eines Klimasystems für eine Datenverarbeitungsanlage, die mindestens einen Server-Schaltschrank zur Aufnahme elektrischer Baugruppen aufweist, wobei von wenigstens einem Klimagerät Warmluft über eine Warmluftansaugung angesaugt, gekühlt und über eine Kaltlufteinblasung mittel- oder unmittelbar in den Server-Schaltschrank oder in einen Kaltgang eingeblasen wird, der von einer Reihe von Server-Schaltschränken begrenzt ist, wobei von wenigstens einem der Server-Schaltschränke Kaltluft aus dem Kaltgang abgesaugt und in einen vom Kaltgang getrennten Warmgang oder in den umgebenden Raum gefördert wird, wobei die Temperatur der Zuluft und Abluft des Klimagerätes mittels Temperatursensoren eingangs- und ausgangsseitig und die Temperatur eines Kühlmediums, welches einen oder mehrere Wärmetauscher im Klimagerät zur Ableitung der Verlustwärme durchströmt, mittels weiterer Temperatursensoren eingangs- und ausgangsseitig bestimmt, ausgewertet und die Leistung mindestens eines Lüfters im Klimagerät gesteuert wird.

Die Erfindung betrifft weiterhin eine entsprechende Vorrichtung zur Durchführung des Verfahrens.

Erfindungsgemäß ist dabei vorgesehen, dass die Regelung der Kühlleistung des Klimagerätes in mindestens zwei unterschiedlichen, vorgebbaren Modi durchgeführt wird, wobei in einem ersten Modus die Luftfördermenge der Lüfter bei einer maximal vorgebbaren Temperaturdifferenz zwischen angesaugter Warmluft und abgegebener Kaltluft auf einen Minimalwert geregelt wird, und in einem zweiten Modus die Kühlleistung derart geregelt wird, dass eine maximal vorgebbare Temperatur für das, aus dem Wärmetauscher strömende Kühlmedium nicht überschritten wird.

Mit dem Verfahren und der Vorrichtung können sowohl Anforderungen hinsichtlich einer energiesparenden Kühlung derartiger Datenverarbeitungsanlagen als auch Anforderungen, wie sie aus einem Facility Management resultieren, erfüllt werden.

Fig. 3

**Beschreibung**

Die Erfindung betrifft ein Verfahren zur Regelung und Überwachung eines Klimasystems für eine Datenverarbeitungsanlage, die mindestens einen Server-Schaltschrank zur Aufnahme elektrischer Baugruppen aufweist, wobei von wenigstens einem Klimagerät Warmluft über eine Warmluftansaugung angesaugt, gekühlt und über eine Kaltlufteinblasung mittel- oder unmittelbar in den Server-Schaltschrank oder in einen Kaltgang eingeblasen wird, der von einer Reihe von Server-Schaltschränken begrenzt ist, wobei von wenigstens einem der Server-Schaltschränke Kaltluft aus dem Kaltgang abgesaugt und in einen vom Kaltgang getrennten Warmgang oder in den umgebenden Raum gefördert wird, wobei die Temperatur der Zuluft und Abluft des Klimagerätes mittels Temperatursensoren eingangs- und ausgangsseitig und die Temperatur eines Kühlmediums, welches einen oder mehrere Wärmetauscher im Klimagerät zur Ableitung der Verlustwärme durchströmt, mittels weiterer Temperatursensoren eingangs- und ausgangsseitig bestimmt, ausgewertet und die Leistung mindestens eines Lüfters im Klimagerät gesteuert wird.

Die Erfindung betrifft weiterhin eine entsprechende Vorrichtung zur Durchführung des Verfahrens.

Datenverarbeitungsanlagen bestehen in der Regel aus einer Vielzahl von Server-Schaltschränken, in die einzelne Elektronik-Einschübe (so genannte Racks) mit eigenen Lüftern mit Kaltluftansaugungen und Warmluftausgängen zur Kühlung eingebaut sind.

Die Server-Schaltschränke sind in mehreren Reihen angeordnet und dabei derart ausgerichtet, dass sich die Kaltluftansaugungen bzw. die Warmluftausgänge der einzelnen Server-Schaltschränke jeweils gegenüber befinden und zwischen den Server-Schaltschränken abwechselnd entsprechende Kaltgänge und Warmgänge ausgebildet sind. Bei einer zweireihigen Anordnung von Server-Schaltschränken ist in der Regel zwischen den beiden Server-Schaltschrankreihen ein Kaltgang ausgebildet. Die Warmluftausgänge der Server-Schaltschränke befinden sich dabei an der Außenseite dieser Anordnung und blasen die Warmluft in den umgebenden Raum ab.

Zur Klimatisierung bzw. insbesondere zur Kühlung dieser Datenverarbeitungsanlagen sind unterschiedliche Konzepte aus dem Stand der Technik bekannt.

So kann beispielsweise vorgesehen sein, dass die von den Server-Schaltschränken ausgeblasene Warmluft zentral von einem Klimasystem angesaugt, gekühlt und die Kaltluft in den Kaltgang eingeblasen wird. Um die Effizienz der Kühlung zu erhöhen, ist in der Regel der Kaltgang gegenüber den Warmgängen bzw. dem umgebenden Raum seitlich und von oben abgeschottet. In den Schriften WO 03/083631 und US 6,859,366 B2 sind beispielsweise derartige Anordnungen beschrieben.

Hinsichtlich einer besonders effektiven Klimatisierung derartiger Anordnungen haben sich so genannte Inline-Klimageräte bewährt, die zwischen den Server-Schaltschränken in bestimmten Abständen, abhängig von der abzuführenden Verlustleistung der Datenverarbeitungsanlage, angeordnet sind. Diese Klimageräte weisen Lüfter auf, die die Warmluft aus den Warmgängen oder aus der umgebenden Luft über Warmluftansaugungen ansaugen, mittels eines oder mehrerer mit Wasser durchströmten Wärmetauschern kühlen und über Kaltlufteinblasungen in die abgeschotteten Kaltgänge einblasen.

Im Produktkatalog "RITTAL Handbuch 32 / IT-Solutions", Seite 726ff. sowie in der Informationsbroschüre "RITTAL IT-Cooling Solutions", 03/08 sind beispielsweise entsprechende Klimageräte unter dem Namen "LCP Inline" aufgeführt. LCP steht für Liquid Cooling Package und beschreibt Klimageräte, welche innerhalb der Datenverarbeitungsanlagen zwischen Server-Schaltschränken platziert werden können und Wärmetauscher mit einer Wasserkühlung aufweisen.

Hinsichtlich einer optimalen Rechnerleistung sowie im Hinblick auf die Betriebszuverlässigkeit ist es erforderlich, dass eingangsseitig den Racks in den Server-Schaltschränken eine Zuluft mit einer bestimmten maximalen Lufttemperatur angeboten wird. Wird diese Temperatur erreicht oder sogar überschritten, kann die Lebensdauer der verbauten Komponenten drastisch reduziert werden, was hohe Servicekosten mit sich bringt. Daher ist es erforderlich, dass die Zuströmung an Kaltluft jeder Zeit dem Bedarf der individuell arbeitenden Racks angepasst wird. Derzeit wird dafür eine Temperatur gesteuerte Regelung der Lüfterleistung eingesetzt. Steigt beispielsweise die Temperatur im Kaltgang an, wird die Lüfterleistung erhöht.

Die DE 10 2005 011 179 B4 beschreibt ein Verfahren zum Überwachen des Kühlbetriebes in einer Geräteanordnung mit einem Aufnahmegehäuse, insbesondere einem Schaltschrank, in dessen Innenraum elektrische Einbauten untergebracht sind und mit einem Kühlgerät. Das Kühlgerät steht über wenigstens einen Lufteinlass und wenigstens eine Ausblasöffnung mit dem Innenraum des Aufnahmegehäuses in luftleitender Verbindung, wobei ein Eingangs-Temperatursensor die Temperatur der über den Lufteinlass zugeführten, zu kühlenden Luft und ein Ausgangs-Temperatursensor die Temperatur der über die Ausblasöffnung ausströmenden, gekühlten Luft misst und wobei mittels einer Rechnereinheit die vom Ausgangs-Temperatursensor gemessenen Temperaturen ausgewertet und zur Regelung des Kühlgerätes verwendet werden. Dabei ist vorgesehen, dass dem Kühlgerät ein Kühlmedium über eine Vorlaufleitung zugeführt und über eine Rücklaufleitung abgeführt wird, wobei der Vorlaufleitung ein Eingangs-Temperatursensor und der Rücklaufleitung ein Ausgangs-temperatursensor zugeordnet sind und von der Recheneinheit ein Differenzsignal aus den von Temperatursensoren in der Vorlauf- und Rücklaufleitung gemessenen Temperaturwerte abgeleitet wird.

Zudem ist dem Kühlgerät, der Vorlauf- oder Rücklaufleitung ein Volumenstrommesser zugeordnet, mit dessen Signal und aus dem Differenzsignal der gemessenen Temperaturen von der Recheneinheit ein der Wärmemenge Q entsprechendes Signal an eine Anzeigeeinheit übermittelt wird. Weiterhin ist dabei vorgesehen, dass entsprechend dem Differenzsignal ein Schaltsignal abgegeben wird, mit dem die Kühlleistung des Kühlgerätes gesteuert wird, wobei, abhängig vom Schaltsignal die Drehzahl wenigstens eines Lüfters des Kühlgerätes gesteuert wird.

Im Allgemeinen kann mit diesem Verfahren eine ausreichend notwendige Kühlleistung zur Verfügung gestellt und bei nicht ausreichendem Kühlbetrieb entsprechend nachgeregelt werden, wobei der Aufwand für eine Überwachung des Kühlbetriebes klein gehalten werden kann. Aktuelle Anforderungen in punkto Energieeffizienz und auch Facility Management erfordern allerdings neue Regelverfahren.

Es ist daher Aufgabe der Erfindung ein Regelverfahren bereitzustellen, welches eine verbesserte bedarfsgerechte Versorgung mit Kaltluft gewährleistet und auch Temperaturanforderungen hinsichtlich des Kühlmediumrücklaufs gerecht wird.

Die das Verfahren betreffende Aufgabe wird dadurch gelöst, dass die Regelung der Kühlleistung des Klimagerätes in mindestens zwei unterschiedlichen, vorgebbaren Modi durchgeführt wird, wobei in einem ersten Modus die Luftfördermenge der Lüfter bei einer maximal vorgebbaren Temperaturdifferenz zwischen angesaugter Warmluft und abgegebener Kaltluft auf einen Minimalwert geregelt wird, und in einem zweiten Modus die Kühlleistung derart geregelt wird, dass eine maximal vorgebbare Temperatur für das, aus dem Wärmetauscher strömende Kühlmedium nicht überschritten wird.

Die die Vorrichtung betreffende Aufgabe wird dadurch gelöst, dass die Regelungseinheit Einrichtungen für einen ersten Regelkreis und einen zweiten Regelkreis zur Regelung der Kühlleistung des Klimagerätes aufweist und mindestens zwei unterschiedliche Betriebsmodi vorgebbar sind, wobei in einem ersten Modus die Luftfördermenge der Lüfter über den ersten Regelkreis bei einer maximal vorgebbaren Temperaturdifferenz zwischen angesaugter Warmluft und abgegebener Kaltluft auf einen Minimalwert regelbar ist, und in einem zweiten Modus mittels des zweiten Regelkreises die Kühlleistung derart regelbar ist, dass eine maximal vorgebbare Temperatur für das, aus dem Wärmetauscher strömende Kühlmedium eingehalten ist.

Mit dem Verfahren und der Vorrichtung kann erreicht werden, dass einerseits eine optimale und zugleich energiesparende Kühlung derartiger Datenverarbeitungsanlagen bereitgestellt wird. Gegenüber dem Stand der Technik wird gerade soviel Luftdurchsatz angeboten, wie er von den einzelnen Server-Schaltschränken als Kaltluft abgesaugt wird. Diese bedarfsgerechte Regelung hilft damit, Energiekosten zu sparen und vor allem auch die Lebensdauer der Lüfter zu verlängern, da diese immer im optimalen Arbeitsbereich betrieben werden können. Andererseits werden auch Anforderungen, wie sie aus einem Facility Management resultieren, erfüllt, wenn auf den zweiten Betriebsmodus umgeschaltet wird. Zu hohe Rücklauftemperaturen für das Kühlmedium können damit vermieden werden.

Bei dem erfindungsgemäßen Verfahren kann vorgesehen sein, dass im ersten Betriebsmodus des Klimagerätes, dem Eco-Modus oder Standard-Modus, als Führungsgröße eine luftseitig einstellbare Temperaturdifferenz verwendet und zur Regelung dieser der Kühlmedium-Durchfluss bei gleich bleibender Luftfördermenge variiert wird. Damit kann insbesondere eine energiesparende Kühlung der Datenverarbeitungsanlage realisiert werden.

Wird bei einer Unterschreitung einer minimal zulässigen Temperatur bei der Kaltlufteinblasung die Luftfördermenge angehoben, kann eine Kondensationen der Luftfeuchtigkeit auf den feuchtempfindlichen elektronischen Bauteilen in den Server-Schaltschränken vermieden werden.

Zur Vermeidung zu hoher Temperaturen beim Kühlmedium-Rücklauf ist bei dem erfindungsgemäßen Verfahren vorgesehen, dass im zweiten Betriebsmodus, dem so genannten Facility Management Modus (FM-Modus) des Klimagerätes eine zweite Regelung der ersten Regelung für die luftseitig einstellbare Temperaturdifferenz übergeordnet wird und als Führungsgröße für diese zweite Regelung eine einstellbare Temperaturdifferenz zwischen Kühlmedium-Vorlauf und Kühlmedium-Rücklauf verwendet wird.

Dabei kann vorgesehen sein, dass, solange die reale Verlustleistung eine projektierte Verlustleistung unterschreitet, das Klimagerät im ersten Betriebsmodus betrieben wird, und dass bei Überschreitung der projektierten Verlustleistung die Lufttemperatur der Kaltlufteinblasung angehoben wird. Damit kann der Differenzwert zwischen Vorlauf-Temperatur und Rücklauf-Temperatur des Kühlmediums über einen großen Kühlleistungsbereich des Klimagerätes auf den festgesetzten erlaubten Wert eingehalten werden, ohne dass die Wirksamkeit der Kühlleistung des Klimagerätes beeinträchtigt wird.

Da aber in diesem FM-Modus zur Einhaltung des maximalen Differenzwertes zwischen Vorlauf-Temperatur und Rücklauf-Temperatur des Kühlmediums die Kühlleistung des Klimagerätes künstlich beschränkt ist, ist vorgesehen, dass bei Aktivierung des zweiten Betriebsmodus des Klimagerätes ein Warnhinweis an einer Warneinrichtung und/ oder einer Serviceeinheit generiert wird. Dies kann beispielsweise mittels einer Klartextwarnmeldung an dem Serviceterminal und/ oder mittels Warnleuchten realisiert sein.

Weiterhin kann vorgesehen sein, dass die Umschaltung auf den zweiten Betriebsmodus des Klimagerätes über die Serviceeinheit zugangskontrolliert durchgeführt wird, so dass diese Umschaltung nur durch fachkundiges Personal durchgeführt werden kann.

Die Vorrichtung sieht dabei in bevorzugter Ausführungsform vor, dass die Regelungseinheit ausgangsseitig mit einer optischen und/ oder akustischen Warneinrichtung und/ oder mit einer übergeordneten Überwachungsanlage der Datenverarbeitungsanlage oder einer Serviceeinheit verbunden ist, über die die Umschaltung auf den zweiten Betriebsmodus des Klimagerätes zugangskontrolliert ermöglicht ist.

In bevorzugter Verfahrensvariante wird als Kühlmedium Wasser verwendet, wobei eine Überwachung der Zuführung an warmem Rücklaufwasser aus den Wärmetauschern an externe Kaltwassersätze durchgeführt wird. Damit kann vermieden werden, dass bei zu hohen Temperaturen des Rücklaufwassers Störungen im Abwassersystem bzw. im Kühlsystem des Gebäudes, in dem sich die Datenverarbeitungsanlage befindet, induziert werden.

In vorteilhafter Weise kann eine Verwendung des Verfahrens, wie es zuvor beschrieben wurde, in Verbindung mit weiteren Regelungsstrategien zur Regelung der Kühlleistung des Klimagerätes vorgesehen sein. So wird beispielsweise in einer noch nicht veröffentlichten Schrift der Anmelderin ein Verfahren und eine Vorrichtung zur Regelung eines Klimasystems für eine Datenverarbeitungsanlage beschrieben, die mindestens eine Reihe von Server-Schaltschränken aufweist, wobei die Reihe von Server-Schaltschränken einen Kaltgang begrenzt, der gegenüber einem, der Kaltgangseite abgewandten Warmgang abgeschottet wird, wobei von wenigstens einem Klimagerät Warmluft angesaugt, gekühlt und in den Kaltgang eingeblasen wird, und wobei von wenigstens einem der Server-Schaltschränke Kaltluft aus dem Kaltgang abgesaugt und in den Warmgang oder in den umgebenden Raum gefördert wird. Dabei ist vorgesehen, dass die Regelung der Luftfördermenge des Klimagerätes mittels einer Druckregelung durchgeführt wird, wobei als Eingangsgröße der Druckregelung eine gemessene Druckdifferenz zwischen einem Drucksensor im Kaltgang oder im Warmgang und einem Drucksensor im umgebenden Raum außerhalb des Kaltgangs oder Warmgangs verwendet wird. Die Vorrichtung weist eine entsprechende Regelungseinheit zur Durchführung des Verfahrens auf. Damit kann erreicht werden, dass einerseits eine optimale und zugleich energiesparende Kühlung derartiger Datenverarbeitungsanlagen bereitgestellt wird. Andererseits wird die Betriebssicherheit erhöht, da Ausfälle oder Defekte bei der Luftförderung unmittelbar detektiert werden können. Zudem können die Anforderungen eines Facility Managements mit berücksichtigt werden.

Die Erfindung wird im Folgenden anhand eines in der Figur dargestellten Ausführungsbeispiels näher erläutert. Es zeigt:

Figur 1     eine Datenverarbeitungsanlage bestehend aus zwei Reihen von Server-Schaltschränken in einer perspektivischen Darstellung;

Figur 2     einen Grundriss einer Datenverarbeitungsanlage mit Server-Schaltschränken und mehreren Klimageräten; und

Figur 3     in schematischer Darstellung ein Klimagerät mit einer Regelungseinheit zur Durchführung des erfindungsgemäßen Regelverfahrens.

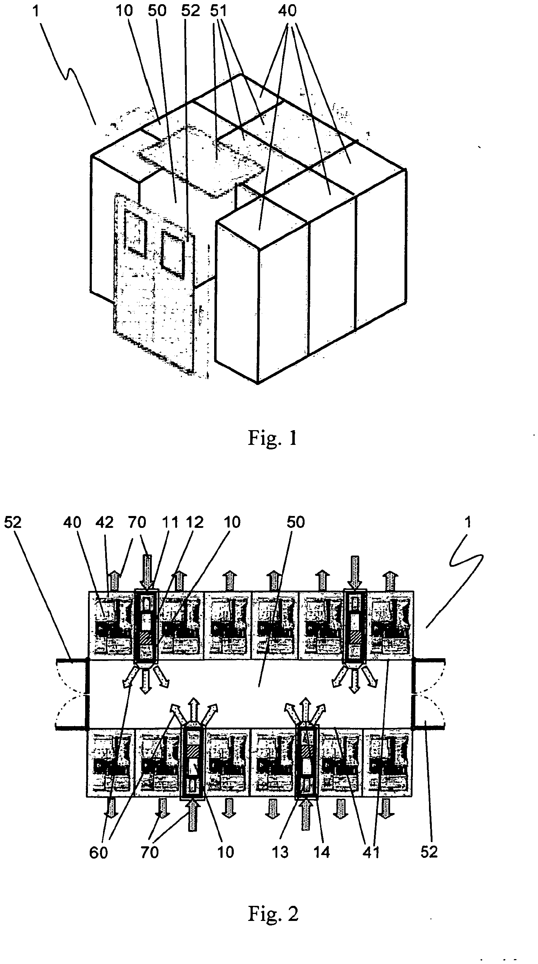

Figur 1 zeigt ausschnittsweise eine eingangs erwähnte Datenverarbeitungsanlage 1, die aus mehreren Server-Schaltschränken 40 aufgebaut ist. Dabei sind die Server-Schaltschränke 40 üblicherweise in zwei Reihen beabstandet angeordnet, so dass ein Kaltgang 50 ausgebildet ist. Der Kaltgang 50 ist mit Platten für eine Deckenabschottung 51 sowie mit Türabschottungen 52 gegenüber dem umgebenden Raum abgeschottet. Zur Kühlung ist ein Klimagerät 10 vorgesehen, welches zwischen den Server-Schaltschränken 40 platziert ist und Warmluft aus dem umgebenden Raum außen ansaugt, diese kühlt und als Kaltluft in den Kaltgang 50 bläst. Jeder der Server-Schaltschränke besitzt eine Vielzahl von Systemeinschüben mit eigenen, voneinander unabhängig arbeitenden Lüftern, die die Kaltluft im Kaltgang 50 ansaugen. Die durch die Verlustleistung erwärmte Luft wird anschließend an den die Datenverarbeitungsanlage 1 umgebenden Raum abgegeben.

An dieser Stelle sei der Hinweis erlaubt, dass sich das erfindungsgemäße Verfahren und die entsprechende Vorrichtung auch auf eine Server-Schaltschrankanordnung bezieht, die nur aus einer Reihe von Server-Schaltschränken 40 besteht und mit einer den Kaltluftansaugungen 41 oder den Warmluftausgängen 42 der Server-Schaltschränke 40 gegenüber befindlichen Wand einen Kaltgang 50 oder einen Warmgang bildet und diese mittels Abschottungen gegenüber dem umgebenden Raum abgetrennt sind. Zudem kann vorgesehen sein, dass die Kaltluft direkt in die Server-Schaltschränke 40 geblasen werden kann.

Figur 2 zeigt einen Grundriss einer Datenverarbeitungsanlage 1 mit mehreren Server-Schaltschränken 40 und mehreren, zwischen den Server-Schaltschränken 40 angeordneten Klimageräten 10, wie sie beispielsweise unter dem Namen "LCP Inline" der Anmelderin bekannt sind.

Die Server-Schaltschränke 40 sind in zwei Reihen angeordnet, wobei zwischen den Reihen ein Kaltgang 50 ausgebildet ist, der mittels Türabschottungen 52 und Deckenabschottungen 51 (in dieser Ansicht nicht sichtbar) vom umgebenden Raum annähernd hermetisch getrennt ist. Mittels der Klimageräte 10 wird über eine Warmluftansaugung 11 Warmluft aus dem umgebenden Raum mittels Lüfter 13 angesaugt und mittels Wärmetauscher 12 gekühlt. Die Wärmetauscher 12 werden dabei mit Kühlwasser durchströmt. Die so gekühlte Luft wird als Kaltluft über Kaltlufteinblasungen 14 dem Kaltgang 50 zugeführt.

Die Server-Schaltschränke 40 besitzen an der dem Kaltgang 50 zugewandten Seite Kaltluftansaugungen 41, über die die Kaltluft aus dem Kaltgang 50 individuell, entsprechend den installierten Systemkomponenten und dem aktuellen Bedarf an Kaltluft, angesaugt werden kann. Die durch die Verlustleistung erwärmte Luft wird über entsprechende Warmluftausgänge 42 wieder dem, die Datenverarbeitungsanlage 1 umgebenden Raum zugeführt.

Die verschieden schattierten Pfeile symbolisieren dabei eine entsprechende Kaltluftströmung 60 und Warmluftströmung 70.

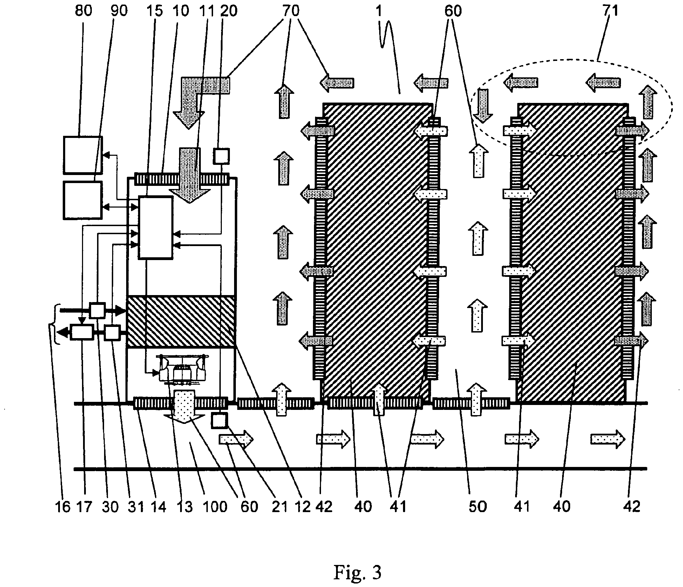

Figur 3 zeigt schematisch die erfindungsgemäße Vorrichtung zur Durchführung des erfindungsgemäßen Verfahrens.

Gezeigt sind als ein Ausschnitt der Datenverarbeitungsanlage 1 ein Klimagerät 10 sowie exemplarisch zwei Server-Schaltschränke 40, welche durch den Kaltgang 50 getrennt gegenüberliegend angeordnet sind.

Die Kaltluft- und die Warmluftströmungen 60, 70 sind in der Figur als Blockpfeile dargestellt. Die Warmluft wird aus dem umgebenden Raum über die Warmluftansaugung 11 des Klimageräts 10 mittels ein oder mehrerer Lüfter 13 angesaugt, wobei üblicherweise eingangsseitig noch Luftfilter vorgesehen sind, die aber hier nicht gezeigt sind. Die warme Luft wird anschließend durch den Wärmetauscher 12 geleitet und die Luft dabei abgekühlt. Der Wärmetauscher 12 besitzt einen Kühlwasserkreislauf 16 mit einem Vor- und einem Rücklauf, über den die, der Luft entzogene Wärme abtransportiert werden kann. Denkbar sind auch Kühlkreisläufe, durch die ein Kältemittel oder eine Kühlsole strömt. Die Kaltluft wird dann über die Kaltlufteinblasung 14 dem Kaltgang 50 zugeführt, wobei diese in einem Doppelboden 100 geführt und über Lüftungsgitter von unten direkt in die Server-Schaltschränke 40 und/ oder indirekt über den Kaltgang 50 den Server-Schaltschränken 40 zugeleitet wird.

Die in den Server-Schaltschränken 40 installierten Datenverarbeitungskomponenten (Racks) saugen die Kaltluft über entsprechende Kaltluftansaugungen 41 an. Die erwärmte Luft strömt dann durch entsprechende Warmluftausgänge 42, die den Kaltluftansaugungen 41 gegenüber liegen, in den die Anordnung umgebenden Raum. Um eine Re-Zirkulation 71 zu verhindern, wie diese sich beim rechten Server-Schaltschrank 40 ausgebildet hat, sind die in Figur 1 und 2 beschriebenen Deckenabschottungen 51 vorgesehen.

Zur Luftmengenregelung ist erfindungsgemäß eine Regelungseinheit 15 vorgesehen, die im gezeigten Beispiel Bestandteil des Klimageräts 10 ist. Denkbar ist auch, dass diese Bestandteil einer übergeordneten Überwachungsanlage der Datenverarbeitungsanlage 1 ist. Dieser sind eingangsseitig Temperatursensoren 20, 21 zur Messung der Lufttemperatur der angesaugten Warmluft sowie der ausgeblasenen Kaltluft sowie weitere Temperatursensoren 30, 31 zur Messung der Wassertemperatur im Vor- und Rücklauf des Kühlwasserkreislaufs 16 aufgeschaltet. Zudem weist der Kühlwasserkreislauf 16 ein Ventil 17 auf, welches als motorisch angetriebenes stetig öffnendes Ventil oder als Magnetventil ausgeführt sein kann und von der Regelungseinheit 15 angesteuert wird. Zudem kann noch ein Durchflussmesser vorgesehen sein, um damit die Wärmemenge bestimmen zu können (siehe dazu die DE 10 2005 011 179 B4). Die Ansteuerung der Lüfter 13 erfolgt im gezeigten Beispiel über die Regelungseinheit 15. Im gezeigten Beispiel sind als externe Baugruppe eine Warneinrichtung 80 (z.B. Warnlicht, Hupe und/ oder übergeordnete Überwachungsanlage) sowie eine als Terminal ausgeführte Serviceeinheit 90 oder eine übergeordnete Überwachungsanlage der Datenverarbeitungsanlage 1 angeschlossen, über die der Status der Klimageräte 10 innerhalb der Datenverarbeitungsanlage 1 angezeigt oder zu Wartungszwecken Befehle eingegeben werden können.

Nachfolgend sind typische Werte bei einer derartigen Anlage genannt. Im Doppelboden 100 beträgt die Lufttemperatur bei der Kaltlufteinblasung 14 typischerweise 16° C bis 20° C, wobei im Doppelboden ein Volumenstrom von 4 bis 6 m/s und ein Überdruck von etwa 40 bis 80 Pa vorherrschen. Die Temperatur der Warmluftströmung 70 nach den Warmluftausgängen 42 der Server-Schaltschränke 40 kann dabei Werte im Bereich von 20° C bis 30° C annehmen. Die Lufttemperatur an der Warmluftansaugung 11 des Klimagerätes 10 kann dabei etwa 22° C bis 24° C betragen.

In dem einen Betriebsmodus, dem so genannten Eco-Modus oder Standard-Modus, wird die Luftfördermenge der Lüfter 13 bei einer maximal vorgebbaren Temperaturdifferenz $\Delta T$ zwischen angesaugter Warmluft und abgegebener Kaltluft derart geregelt, dass die Lüfter 13 auf einem geringstmöglichen Luftvolumenstrom gehalten werden, bei dem das maximal größtmögliche $\Delta T$, welches einstellbar ist, nicht überschritten wird. Die Führungsgröße ist somit das luftseitige $\Delta t$. Die Regelung des Wasserkreises dient nur noch dazu, die Zulufttemperatur im vorgegebenen Bereich von typisch 20° C bis 25° C, welcher einstellbar ist, zu halten. Bevor die Lüfterdrehzahl und damit der Volumenstrom erhöht wird, muss durch Erhöhung des wasserseitigen Durchflusses versucht werden, das luftseitige $\Delta T$ konstant zu halten. Bei einer Unterschreitung der minimal zulässigen Server-Einblastemperatur ist der Volumenstrom anzuheben. Der typische Arbeitspunkt im Eco-Modus ist eine größtmögliche Server-Zulufttemperatur und größtmögliches luftseitiges $\Delta t$. In dieser Regelungsvariante führt das Klimagerät 10 die Server luftseitig. Es wird immer genau die Luftmenge umgewälzt, die zur Maximierung des zulässigen $\Delta T$´s notwendig ist. Dabei werden die Server tendenziell am thermodynamischen Limit betrieben. Damit kann erreicht werden, dass die elektrische Leistungsaufnahme und somit die Betriebskosten für die Lüfter auf ein Minimum reduziert werden können.

Im zweiten Betriebszustand, dem so genannten Facility Management Modus (FM-Modus), wird eine Regelung nach konstantem wasserseitigen $\Delta T$ durchgeführt, um zu vermeiden, dass externe Kaltwassersätze zu warmes Rücklaufwasser zugeführt bekommen und somit eventuell Störungen auftreten können. Hierbei gilt.

$$\text{Wasservorlauftemperatur} + \Delta T = \text{Wasserrücklauftemperatur} \qquad (1)$$

Die Vorlauftemperatur kann dabei mit dem Temperatursensor 30 erfasst werden, wobei lediglich ein maximal erlaubter Wert für das $\Delta T$ einzugeben ist.

Dazu folgendes Beispiel:

Projektierte Verlustleistung 10 kW
Vorlauftemperatur (gemessen) 12° C
Vorgegebenes $\Delta T$ 6 K, was einer maximalen Rücklauftemperatur von 18° C entspricht

Die Server-Zulufttemperatur ergibt sich nach einer entsprechenden Kennlinie für das Klimagerät 10. So lange die reale Verlustleistung kleiner ist als die projektierte Verlustleistung, regelt das Gerät im Standardmodus. Steigt die reale Verlustleistung über die maximal projektierte Verlustleistung an, wird die Server-Zulufttemperatur ebenfalls nach oben ansteigen. Dabei ist vorgesehen, dass ein Warnhinweis bei Aktivierung des FM-Modus aktiviert wird, der sinngemäß wie folgt lauten kann: "Achtung, maximale Kühlleistung wurde künstlich beschränkt! Ist die reale Verlustleistung größer als die projektierte Verlustleistung, kann der Sollwert der Server-Zulufttemperatur nicht mehr gehalten werden"

Ein Umschalten zwischen diesen Modi ist daher mittels einer Zugangskontrolle, z.B. über ein Passwort auf der Serviceseite der Serviceeinheit 90 oder der übergeordneten Überwachung der Datenverarbeitungsanlage 1 zu schützen. Änderungen dürfen nur durch fachkundiges Servicepersonal durchgeführt werden.

Mit dem Verfahren und der Vorrichtung kann erreicht werden, dass einerseits eine optimale und zugleich energiesparende Kühlung derartiger Datenverarbeitungsanlagen 1 bereitgestellt wird. Andererseits werden auch Anforderungen, wie sie aus einem Facility Management resultieren, erfüllt.

**Patentansprüche**

1. Verfahren zur Regelung und Überwachung eines Klimasystems für eine Datenverarbeitungsanlage (1), die mindestens einen Server-Schaltschrank (40) zur Aufnahme elektrischer Baugruppen aufweist, wobei von wenigstens einem Klimagerät (10) Warmluft über eine Warmluftansaugung (11) angesaugt, gekühlt und über eine Kaltlufteinblasung (14) mittel- oder unmittelbar in den Server-Schaltschrank (40) oder in einen Kaltgang (50) eingeblasen wird, der von einer Reihe von Server-Schaltschränken (40) begrenzt ist, wobei von wenigstens einem der Server-Schaltschränke (40) Kaltluft aus dem Kaltgang (50) abgesaugt und in einen vom Kaltgang (50) getrennten Warmgang oder in den umgebenden Raum gefördert wird, wobei die Temperatur der Zuluft und Abluft des Klimagerätes (10) mittels Temperatursensoren (20, 21) eingangs- und ausgangsseitig und die Temperatur eines Kühlmediums, welches einen oder mehrere Wärmetauscher (12) im Klimagerät (10) zur Ableitung der Verlustwärme durchströmt, mittels weiterer Temperatursensoren (30, 31) eingangs-und ausgangsseitig bestimmt, ausgewertet und die Leistung mindestens eines Lüfters (13) im Klimagerät (10) gesteuert wird,
**dadurch gekennzeichnet,**
**dass** die Regelung der Kühlleistung des Klimagerätes (10) in mindestens zwei unterschiedlichen, vorgebbaren Modi durchgeführt wird, wobei in einem ersten Modus die Luftfördermenge der Lüfter (13) bei einer maximal vorgebbaren Temperaturdifferenz zwischen angesaugter Warmluft und abgegebener Kaltluft auf einen Minimalwert geregelt wird, und in einem zweiten Modus die Kühlleistung derart geregelt wird, dass eine maximal vorgebbare Temperatur für das, aus dem Wärmetauscher (12) strömende Kühlmedium nicht überschritten wird.

2. Verfahren nach Anspruch 1,
**dadurch gekennzeichnet,**
**dass** im ersten Betriebsmodus des Klimagerätes (10) als Führungsgröße eine luftseitig einstellbare Temperaturdifferenz verwendet und zur Regelung dieser der Kühlmedium-Durchfluss bei gleich bleibender Luftfördermenge variiert wird.

3. Verfahren nach Anspruch 1 oder 2,
**dadurch gekennzeichnet,**

**dass** bei einer Unterschreitung einer minimal zulässigen Temperatur bei der Kaltlufteinblasung (14) die Luftfördermenge angehoben wird.

4. Verfahren nach einem der Ansprüche 1 bis 3,
   **dadurch gekennzeichnet,**
   **dass** im zweiten Betriebsmodus des Klimagerätes (10) eine zweite Regelung der ersten Regelung für die luftseitig einstellbare Temperaturdifferenz übergeordnet wird und als Führungsgröße für diese zweite Regelung eine einstellbare Temperaturdifferenz zwischen Kühlmedium-Vorlauf und Kühlmedium-Rücklauf verwendet wird.

5. Verfahren nach einem der Ansprüche 1 bis 4,
   **dadurch gekennzeichnet,**
   **dass**, solange die reale Verlustleistung eine projektierte Verlustleistung unterschreitet, das Klimagerät (10) im ersten Betriebsmodus betrieben wird, und dass bei Überschreitung der projektierten Verlustleistung die Lufttemperatur der Kaltlufteinblasung (14) angehoben wird.

6. Verfahren nach einem der Ansprüche 1 bis 5,
   **dadurch gekennzeichnet,**
   **dass** bei Aktivierung des zweiten Betriebsmodus des Klimagerätes (10) ein Warnhinweis an einer Warneinrichtung (80) und/ oder einer Serviceeinheit (90) generiert wird.

7. Verfahren nach einem der Ansprüche 1 bis 6,
   **dadurch gekennzeichnet,**
   **dass** die Umschaltung auf den zweiten Betriebsmodus des Klimagerätes (10) über die Serviceeinheit (90) zugangskontrolliert durchgeführt wird.

8. Verfahren nach einem der Ansprüche 1 bis 7,
   **dadurch gekennzeichnet,**
   **dass** als Kühlmedium Wasser verwendet und eine Überwachung der Zuführung an warmem Rücklaufwasser aus den Wärmetauschern (12) an externe Kaltwassersätze durchgeführt wird.

9. Verwendung des Verfahrens nach einem der Ansprüche 1 bis 8 in Verbindung mit weiteren Regelungsstrategien zur Regelung der Kühlleistung des Klimagerätes (10).

10. Vorrichtung zur Regelung und Überwachung eines Klimasystems für eine Datenverarbeitungsanlage (1), die mindestens einen Server-Schaltschrank (40) zur Aufnahme elektrischer Baugruppen aufweist, wobei von wenigstens einem Klimagerät (10) Warmluft über eine Warmluftansaugung (11) angesaugt sowie gekühlt wird und über eine Kaltlufteinblasung (14) mittel- oder unmittelbar in den Server-Schaltschrank (40) oder in einen Kaltgang (50) einbringbar ist, der von einer Reihe von Server-Schaltschränken (40) begrenzt ist, wobei von wenigstens einem der Server-Schaltschränke (40) Kaltluft aus dem Kaltgang (50) ansaugbar und in einen vom Kaltgang (50) getrennten Warmgang oder in den umgebenden Raum förderbar ist, wobei die Temperatur der Zuluft and Abluft des Klimagerätes (10) mittels Temperatursensoren (20, 21) eingangs- und ausgangsseitig und die Temperatur eines Kühlmediums, welches einen oder mehrere Wärmetauscher (12) im Klimagerät (10) zur Ableitung der Verlustwärme durchströmt, mittels weiterer Temperatursensoren (30, 31) eingangs-und ausgangsseitig bestimmbar und mittels einer Regelungseinheit (15) des Klimagerätes (10), die mit den Temperatursensoren (20, 21, 30, 31) verbunden ist, auswertbar und die Leistung mindestens eines Lüfters (13) im Klimagerät (10) steuerbar ist,
    **dadurch gekennzeichnet,**
    **dass** die Regelungseinheit (15) Einrichtungen für einen ersten Regelkreis und einen zweiten Regelkreis zur Regelung der Kühlleistung des Klimagerätes (10) aufweist und mindestens zwei unterschiedliche Betriebsmodi vorgebbar sind, wobei in einem ersten Modus die Luftfördermenge der Lüfter (13) über den ersten Regelkreis bei einer maximal vorgebbaren Temperaturdifferenz zwischen angesaugter Warmluft und abgegebener Kaltluft auf einen Minimalwert regelbar ist, und in einem zweiten Modus mittels des zweiten Regelkreises die Kühlleistung derart regelbar ist, dass eine maximal vorgebbare Temperatur für das, aus dem Wärmetauscher (12) strömende Kühlmedium eingehalten ist.

11. Vorrichtung nach Anspruch 10,
    **dadurch gekennzeichnet,**
    **dass** die Regelungseinheit (15) ausgangsseitig mit einer optischen und/ oder akustischen Warneinrichtung (80) und/ oder mit einer übergeordneten Überwachungsanlage der Datenverarbeitungsanlage (1) oder einer Serviceeinheit (90) verbunden ist, über die die Umschaltung auf den zweiten Betriebsmodus des Klimagerätes (10) zu-

gangskontrolliert ermöglicht ist.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 03083631 A
- US 6859366 B2
- DE 102005011179 B4